# EUROPEAN PATENT SPECIFICATION

(11) **EP 1 166 288 B1**
(45) Date of publication and mention of the grant of the patent: **18.05.2005**
(21) Application number: 01901523.9
(22) Date of filing: 24.01.2001
(51) Int. Cl.: H01F 1/00, H01F 10/00, H01F 41/30

(54) **MAGNETIC SUBSTANCE WITH MAXIMUM COMPLEX PERMEABILITY IN QUASI-MICROWAVE BAND AND METHOD FOR PRODUCTION OF THE SAME**
MAGNETMATERIAL MIT MAXIMUM-KOMPLEX-PERMEABILITÄT IN QUASI-MIKROWELLENBEREICH UND HERSTELLUNGSVERFAHREN
SUBSTANCE MAGNETIQUE A PERMEABILITE COMPLEXE MAXIMALE DANS UNE BANDE DE QUASI-HYPERFREQUENCES ET PROCEDE DE PRODUCTION D'UNE TELLE SUBSTANCE

(30) Priority: 24.01.2000 JP 2000052507
(43) Date of publication of application: 02.01.2002
(60) Divisional application: 03022559.3
(73) Proprietor: NEC TOKIN Corporation, Sendai-shi, Miyagi (JP)
(72) Inventor: YOSHIDA, Shigeyoshi c/o TOKIN CORPORATION, Sendai-shi, Miyagi 982-8510 (JP); ONO, Hiroshi c/o TOKIN CORPORATION, Sendai-shi, Miyagi 982-8510 (JP); ANDOH, Shinsuke c/o TOKIN CORPORATION, Sendai-shi, Miyagi 982-8510 (JP); LI, Wei-Dong c/o TOKIN CORPORATION, Sendai-shi, Miyagi 982-8510 (JP); SHIMADA, Yutaka, Sendai-shi, Miyagi 981-0961 (JP)
(74) Representative: Prüfer, Lutz H., Dipl.-Phys.
(86) International application number: PCT/JP2001/000437
(87) International publication number: WO 2001/054145

(56) References cited:
- EP-A- 0 859 378
- EP-A- 1 020 878
- S.H.HAN ET AL: "Soft Magnetic Properties of Fe-(Si3N4,Al2O3) Thin Films" IEEE TRANSACTIONS ON MAGNETICS., vol. 32, no. 5, September 1996 (1996-09), pages 4499-4501, XP000634050 IEEE INC. NEW YORK., US ISSN: 0018-9464
- YOSHIDA S ET AL: "PERMEABILITY AND ELECTROMAGNETIC-INTERFERENCE CHARACTERISTICS OF FE-SI-AL ALLOY FLAKES-POLYMER COMPOSITE" JOURNAL OF APPLIED PHYSICS,US,AMERICAN INSTITUTE OF PHYSICS. NEW YORK, vol. 85, no. 8, PART 02A, 15 April 1999 (1999-04-15), pages 4636-4638, XP000823627 ISSN: 0021-8979
- PATENT ABSTRACTS OF JAPAN vol. 1999, no. 01, 29 January 1999 (1999-01-29) & JP 10 270246 A (RES INST ELECTRIC MAGNETIC ALLOYS), 9 October 1998 (1998-10-09)

## Description

### Technical Field of the Invention

This invention relates to a magnetic substance for use in suppression or absorption of a high frequency noise in an electric and electronic apparatus and, in particular, to such a magnetic substance adapted for use in suppression of electromagnetic interference (EMI) caused in an active electronic element, a high frequency circuit component, and a high frequency electronic apparatus.

### Technical Background

It is well known in the art that a cylindrical ferrite core is attached onto an electric power cord to an electronic apparatus, for example, computer so as to suppressing a high frequency noise from flowing into, or from, the computer through the electric power cord. The ferrite core absorbs the high frequency noise current flowing through the power cord. The ferrite core used has a large volume in comparison with electronic apparatus which have rapidly been small-sized with electronic circuit components disposed at a high density.

It is also well known in the art that a concentrated constant circuit such as a decoupling capacitor is assembled in a power circuit line in the electronic apparatus so as to suppressing undesired radiation from the power line.

It is also another problem that a high frequency noise is often caused by or induced from a semiconductor or an integrated circuit device of a high speed operation type such as a random access memory (RAM), a read only memory (ROM), a microprocessor (MPU), a central processing unit (CPU), or an image processor arithmetic logic unit (IPALU) because an electric signal flows in a high speed circuit therein with rapid change in current and voltage value.

In addition, electronic elements and cables are disposed with a high density in a small-sized electronic apparatus. Therefore, those elements and lines are very close to each other and thereby affected to each other to cause the EMI.

In order to suppress the high frequency noise from those semiconductor devices and the EMI within the small-sized electronic apparatus, the conventional ferrite core cannot be used because it has a relatively large volume.

On the other hand, use of the concentrated constant circuit cannot sufficiently suppress the high frequency noise caused in the circuit using electronic elements of the high speed operation type because the noise has an increased frequency so that the circuit line actually acts as a distributed constant circuit.

JP-A 10-97913 discloses a complex magnetic substance having a relatively large core loss or complex permeability. The complex magnetic substance is disposed adjacent a semiconductor device and/or electronic circuit device and can suppress a high frequency noise radiated therefrom.

It is understood from the recent research that use of the magnetic substance having the complex permeability µ" is considered as an effective resistance added to the circuit generating the noise so that the noise can be attenuated. The effective resistance is dependent on the complex permeability µ" of the magnetic substance used. In detail, providing that the magnetic substance has a constant area, it is certain that the effective resistance is dependent on the complex permeability µ" and the thickness of the magnetic substance. This means that magnetic substance having an increased complex permeability could provide a high frequency noise suppressor with a reduced volume, that is, a reduced size in area and thickness, which could be assembled within a small size apparatus.

From S.H. Han et al. :"Soft magnetic properties of FE-(Si₃N₄,Al₂O₃) thin films", IEEE transactions on magnetics, vol.32, no. 5, September 1996, pages 4409-4501, New York, US, ISSN 0018-9464 the compounds FE-Si₃N₄ and Fe-Al₂O₃ can be taken wherein the saturation magnetisation decreases inversely with the logarithm of the electrical resistivity. Fe-Si₃N₄ has an electrical resistivity of about 800µΩ-cm and a permeability at 100MHz higher than 400.

EP 102 878 A discloses the compound TₐM_{b}X_{c}N_{d}Oₑ (T=Fe; M=Be, Mg, or Ca; X=Y, Ti, Zr, Hf, V, Nb, Ta and/or lanthanoid ), which has a saturation flux density of not less than 0.8T and an electric resistivity of not less than 80 µΩ-cm.

JP 10-270 246 A discloses a compound Co_{100-x-y-z}Fe_{x-y} M_{y}O_{z} which has an anisotropic magnetic filed of 200e or more, a specific resistance of 50µΩ-cm or more and a saturation flux density of 16kG (1.6 T) or more. Fe-Ta-N is disclosed having a maximum of µ" as shown in fig. 11 thereof, Fe-Ta-N is shown as a comparative sample having a problem that a magnetic resonance is caused.

From EP 0 991 087 A2, which forms prior art under Art. 54(3) EPC, a soft magnetic film can be taken which can be used for noise suppression. It is a sputtered Fe-Hf-Pt•N film, having a saturation magnetization of 1.5 - 1.6 T. The maximum of the complex permeability is above 1 GHZ.

From S. Yoshida et al.: "Permeability and electromagnetic-interference characteristics of Fe-Si-Al alloy flakes-polymer composite" in Journal of Applied Physics, New York, Vol. 85, No. 8, Part 02A 15 April 1999, pages 4636-4638 a suppressor can be taken having a magnetic composition comprising M, X and Y. Fe-Si-Al flakes are disclosed which have an oxidized surface. The magnetic substance is optimized by varying the attrition time.

### Summary of the invention

The invention relates to the use of a magnetic substance for suppression of a high frequency noise as is claimed in claim 1.

Preferred developments of the invention are defined in the dependent claims.

### Detailed description

As one of magnetic substance having a low core loss and a high saturation magnetization, a M-X-Y magnetic composition (M: magnetic metallic element, Y: O, N, or F, X: element or elements other than M and Y) is known in the prior art, which is mainly produced by the sputtering method or the vapor deposition method and has a granular structure where metallic magnetic particles of M are dispersed in a non-magnetic matrix (X and Y)like ceramics.

During searching fine structures of the M-X-Y magnetic composition having the excellent permeability, the present co-inventors found out that the high saturation magnetization can be realized in a high concentration region of M where the M-X-Y magnetic composition has a saturation magnetization of 80% or more of that of the metallic bulk of magnetic material comprising M alone.

The M-X-Y magnetic composition has a low specific resistance. Therefore, when it is formed in a part having a relatively thickness which is used in a high frequency range, the part permits an eddy current to flow therein. As a result, the part is reduced in permeability. Therefore, the conventional M-X-Y magnetic composition having the high saturation magnetization cannot be used for part having an increased thickness.

The present inventors further found out that the M-X-Y magnetic composition having a reduced concentration of M has an increased complex permeability µ" in a high frequency range. In a reduced concentration region of M where the M-X-Y magnetic composition has a saturation magnetization of 60-80% of that of the metallic bulk of magnetic material comprising M alone, the M-X-Y magnetic composition has a relatively high specific resistance of about 100 µΩ · cm or more. Therefore, if a part having a relative thickness such as several micrometers (µm)is formed of the composition with the reduced concentration of M, it shows a reduced loss due to the eddy current. The core loss or complex permeability is a loss due to the natural resonance. Therefore, the distribution of the complex permeability on a frequency axis is narrow. This means that the M-X-Y magnetic composition with the reduced concentration of M is useful for suppression of noise within a narrow frequency range.

In a further reduced concentration of M where the M-X-Y magnetic composition has a saturation magnetization of 35-60% of that of the metallic bulk of magnetic material comprising M alone, the M-X-Y magnetic composition has a higher specific resistance about 500µΩ · cm or more. Therefore, the loss due to the eddy current is further reduced in a part made of the composition and having a relative thickness such as several micrometers (µm). Magnetic mutual effect between M particles becomes small so that the spin heat fluctuation becomes large to cause fluctuation of that frequency at which the natural resonance of the complex permeability generates. Therefore, the complex permeability µ" has a relatively large value over a broad frequency range. This means that the M-X-Y magnetic composition with the further reduced concentration of M is useful for suppression of noise within a broad frequency range.

In a more reduced concentration of M, particles of M do not magnetically effect to each other so that the M-X-Y composition exhibits the superparamagnetism.

In design of a part made of magnetic substance to be disposed adjacent an electronic circuit so as to suppress a high frequency noise, a value of a product (µ" · δ) of the complex permeability µ" and a thickness 6 of the magnetic substance is considered. Generally, (µ" · δ) ≧ 1000 µm is required for effectively suppressing high frequency noise of hundreds megahertz (MHz). When the magnetic composition used has the complex permeability of about 1000 (µ"=1000), the noise suppressor is required to have a thickness of 1 micrometer (µm) or more. Therefore, the composition having a low specific resistance is not desired because the eddy current is easily generated but is desired to have an increased specific resistance such as 100 µ · Ω · cm or more.

In the view point of the above, M-X-Y composition used for the noise suppressor is desired to have a reduced concentration of M where the M-X-Y magnetic composition has a saturation magnetization of 35-80% of that of the metallic bulk of magnetic material comprising M alone.

### Brief Description of the Drawing

Fig. 1 is a schematic view showing a granular structure of M-X-Y magnetic composition;
Fig. 2A is a schematic sectional view showing a structure of a sputtering apparatus which was used in examples;
Fig. 2B is a schematic sectional view showing a structure of a vapor deposition apparatus which was used in examples;
Fig. 3 is a graphical view showing a frequency response of a complex permeability of film sample 1 in Example 1;
Fig. 4 is a graphical view showing a frequency response of a complex permeability of film sample 2 in Example 2;
Fig. 5 is a graphical view showing a frequency response of a complex permeability of comparable sample 1 in Comparable Example 1;
Fig. 6 is a schematic and perspective view of a test apparatus for testing an noise suppressing effect of magnetic samples;
Fig. 7A is a graphic view showing a transmission characteristic of film sample 1;
Fig. 7B is a graphic view showing a transmission characteristic of comparable sample of composite magnetic material sheet;
Fig. 8A is a distribution constant circuit with a length ℓ showing a magnetic material as a noise suppressor;
Fig. 8B is an equivalent circuit with a unit length Δℓ of the distribution constant circuit of Fig. 8A;
Fig. 8C is an equivalent circuit with a length ℓ of the distribution constant circuit of Fig. 8A;
Fig. 9A is a graphic view showing a frequency response of an equivalent resistance R of film sample 1 in Example 1; and
Fig. 9B is a graphic view showing a frequency response of an equivalent resistance R of comparative sample of a composite magnetic material sheet.

### Embodiments of the Invention

At first, description will be made as to granular structure and production methods of M-X-Y magnetic composition.

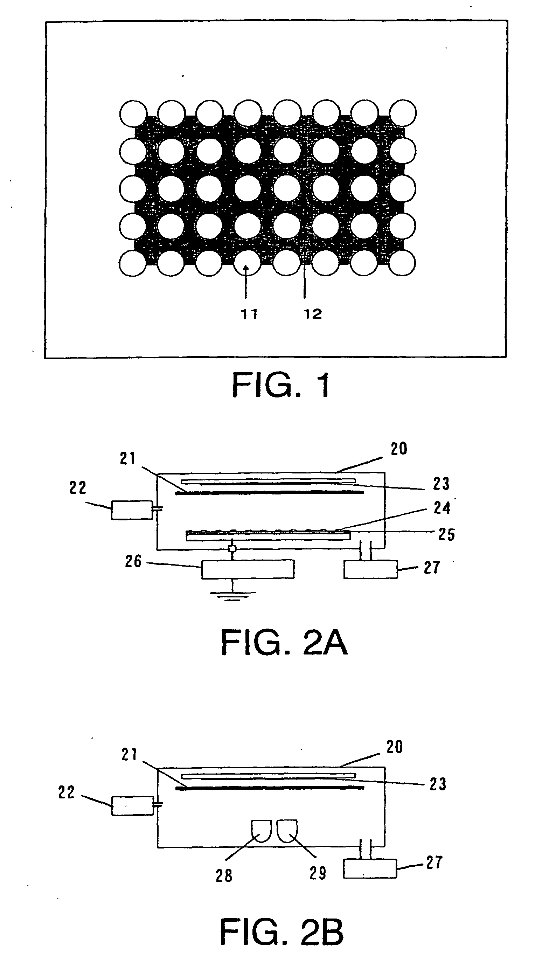

Referring to Fig. 1 in which schematically shows the granular structure of M-X-Y magnetic composition, particles 11 of metallic magnetic material M are uniformly or evenly distributed in a matrix 12 consisting of X and Y.

Referring to Fig. 2A, a sputtering apparatus shown therein was used for producing samples in the following examples and comparative examples. The sputtering apparatus has a conventional structure and comprises a vacuum container 20, a shutter 21, an atmospheric gas source 22, a substrate or a glass plate 23, chips 24 (X or X-Y), a target 25 (M), an RF power source, and a vacuum pump 27. The atmospheric gas source 22 and the vacuum pump 27 are connected to the vacuum container 20. The substrate 23 confronts to the target 25 on which chips 24 are disposed. The shutter 21 is disposed in front of the substrate 21. The RF power source 26 is connected to the target 25.

Referring to Fig. 2B, a vapor deposition apparatus shown therein was also used another apparatus for producing samples in the following examples and comparative examples. The vapor deposition apparatus has a conventional structure and has vacuum container 20, atmospheric gas source 22, and vacuum pump 27 similar to the sputtering apparatus but has a crucible 28 including materials (X-Y) in place of chips 24, target 25 and RF power source 26.

### Example 1

A thin film of M-X-Y magnetic composition was made on a glass plate by use of the sputtering apparatus shown in Fig. 2A at a sputtering condition shown in Table 1.

**Table 1**

| | |
|---|---|
| Vacuum degree before sputtering | < 1.33 × 10⁻⁴ Pa (1 × 10⁻⁶ Torr ) |
| Atmosphere | Ar gas |
| Electric Power | RF |
| Targets | Fe (diameter of 100mm) and Al₂O₃ chip (120 pieces) (chip size: 5mm × 5mm × 2mm) |

The film sample 1 produced was analyzed by a fluorescent X-ray spectroscopy and confirmed as a film of a composition Fe₇₂Al₁₁O₁₇. The film sample 1 had 2.0 micrometer (µm) in thickness, 530 micro ohm centimeters (µΩ · cm) in DC specific resistance, 1433 A/m (18 Oe) in anisotropy field (Hk), and 1.68 T (16,800 Gauss) in saturation magnetization (Ms).

A percent ratio of the saturation magnetization of the film sample 1 and that of the metallic material M itself {Ms(M-X-Y)/Ms(M)} × 100 was 72.2%.

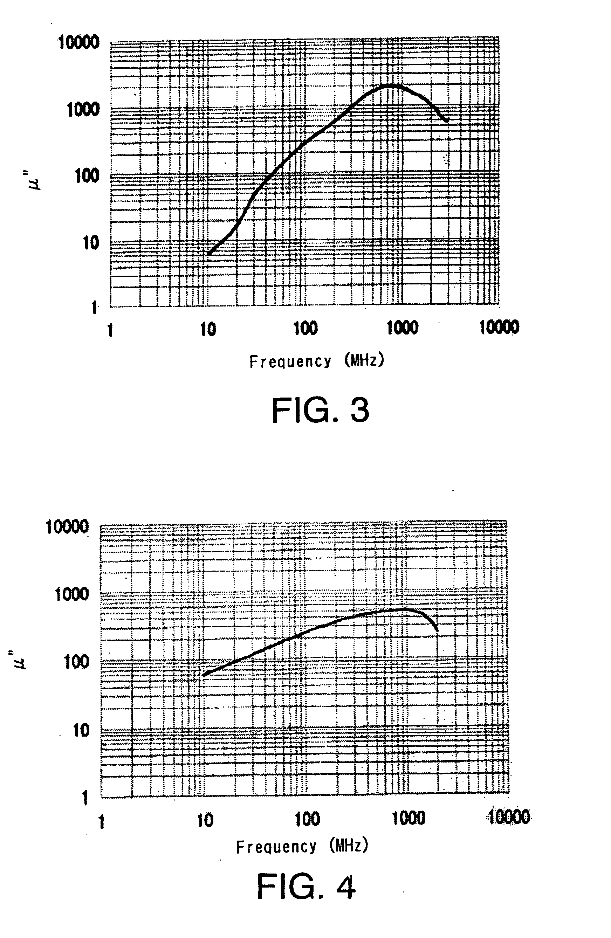

In order to measure a permeability frequency response, the film sample 1 was formed in a ribbon like form and inserted in a coil. Under application of a bias magnetic field, an impedance variation of the coil was measured in response to frequency change of AC current applied to the coil. The measurement was several times for different values of the bias magnetic field. From the measured impedance variation in response to frequency variation, the complex permeability frequency response (µ"-f response) was calculated and is shown in Fig. 3. It will be noted from Fig. 3 that the complex permeability has a high peak or the maximum value (µ"ₘₐₓ) and rapidly falls either side of the peak. The natural resonance frequency (f( µ"ₘₐₓ)) showing the maximum value (µ"ₘₐₓ) is about 700 MHz. From the µ"-f response, a relative bandwidth bwr was determined as a percentage ratio of bandwidth between two frequency points which shows the complex permeability as a half value µ"₅₀ of the maximum µ"ₘₐₓ, to center frequency of said bandwidth. The relative bandwidth bwr was 148%.

### Example 2

In a condition similar to that in Example 1 but using of 150 Al₂O₃ chips, a film sample 2 was formed on a glass plate.

The film sample 2 produced was analyzed by a fluorescent X-ray spectroscopy and confirmed as a film of a composition Fe₄₄Al₂₂O₃₄. The film sample 2 had 1.2 micrometer (µm) in thickness, 2400 micro ohm centimeters (µΩ · cm) in DC specific resistance, 9550 A/m (120 Oe) in anisotropy field (Hk), and 0.96 T (9600 Gauss) in saturation magnetization (Ms). It will be noted that film sample 2 is higher than film sample 1 in the specific resistance.

A percent ratio of the saturation magnetization of the film sample 2 and that of the metallic material M itself {Ms(M-X-Y)/Ms(M)} × 100 was 44.5%.

The µ"-f response of film sample 2 was also obtained in the similar manner as in Example 1 and shows in Fig. 4. It is noted that the peak has also a high value similar to that in film sample 1. However, the frequency point at the peak, or the natural resonance frequency is about 1 GHz and the complex permeability gradually falls either side of the peak so that the µ"-f response has a broadband characteristic.

A relative bandwidth bwr of film sample 2 was also confirmed as 181% by the similar way as in Example 1.

### Comparative Example 1

In a condition similar to that in Example 1 but using of 90 Al₂O₃ chips, a comparative sample 1 was formed on a glass plate.

The comparative sample 1 produced was analyzed by a fluorescent X-ray spectroscopy and confirmed as a film of a composition Fe₈₆Al₆O₈. The comparative sample 1 had 1.2 micrometer (µm) in thickness, 74 micro ohm centimeters (µΩ · cm) in DC specific resistance, 1751 A/m (22 Oe) in anisotropy field (Hk), 1.88 T (18,800 Gauss) in saturation magnetization (Ms), and 85.7% in a percent ratio of the saturation magnetization of the comparative sample 1 and that of the metallic material M itself {Ms(M-X-Y)/Ms(M)} × 100, and was 44.5%.

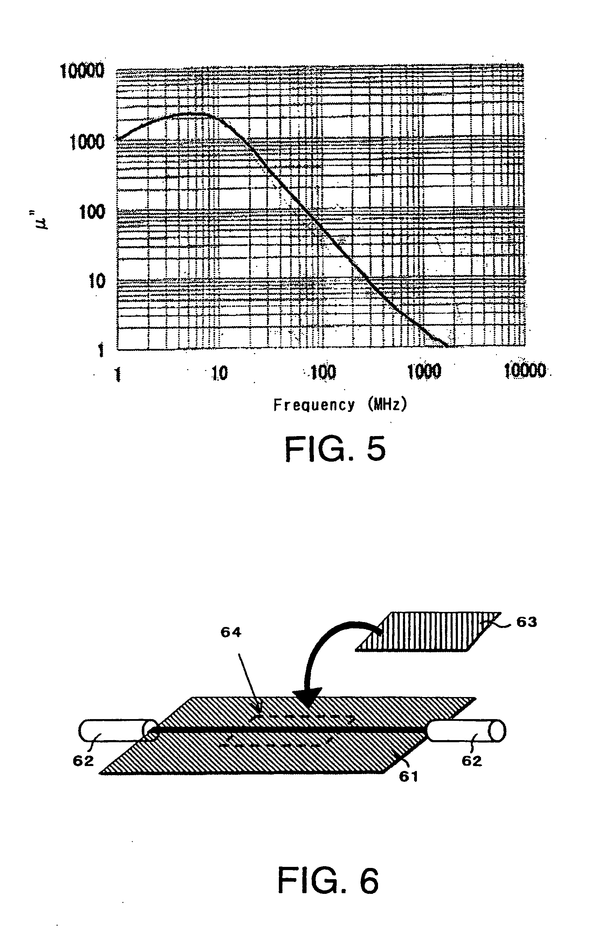

The µ"-f response of comparative sample 1 was also obtained in the similar manner as in Example 1, and is shown in Fig. 5. It will be noted from Fig. 5 that the complex permeability µ" of the comparative sample 1 has a high peak at a frequency about 10 MHz but rapidly reduces at the higher frequency range than 10 MHz. It can be supposed that this reduction is caused by generation of eddy current due to the lower specific resistance.

### Comparative Example 2

In a condition similar to that in Example 1 but using of 200 Al₂O₃ chips, a comparative sample 2 was formed on a glass plate.

The comparative sample 2 produced was analyzed by a fluorescent X-ray spectroscopy and confirmed as a film of a composition Fe₁₉Al₃₄O₄₇. The comparative sample 2 had 1.3 micrometer (µm) in thickness, 10,500 micro ohm centimeters (µΩ · cm) in DC specific resistance.

The magnetic characteristic of comparative sample 1 exhibited superparamagnetism.

### Example 4

A thin film of M-X-Y magnetic composition was made on a glass plate by the reactive sputtering method using the sputtering apparatus shown in Fig. 2A at a sputtering condition shown in Table 2. The partial pressure ratio of N₂ was 20%. The thin film was heat-treated at a temperature of 300°C for two hours in vacuum under magnetic field and obtained a film sample 4.

**Table 2**

| | |
|---|---|
| Vacuum degree before sputtering | < 1.33 × 10⁻⁴ Pa (1 × 10⁻⁶ Torr ) |
| Atmosphere | Ar+N₂ gas |
| Electric Power | RF |
| Targets | Fe (diameter of 100mm) and Al chip (150 pieces) (chip size: 5mm × 5mm × 2mm) |

The properties of film sample 4 are show in Table 3.

**Table 3**

| | |
|---|---|
| Film thickness | 1.5 µm |
| {Ms(M-X-Y)/Ms(M)} × 100 | 51.9% |
| µ"ₘₐₓ | 520 |
| f( µ"ₘₐₓ) | 830MHz |
| bwr | 175% |

### Example 5

A thin film of M-X-Y magnetic composition was made on a glass plate by using the sputtering apparatus shown in Fig. 2A at a sputtering condition shown in Table 4. The thin film was heat-treated at a temperature of 300°C for two hours in vacuum under magnetic field and obtained a film sample 5.

**Table 4**

| | |
|---|---|
| Vacuum degree before sputtering | < 1.33 × 10⁻⁴ Pa (1 × 10⁻⁶ Torr) |
| Atmosphere | Ar gas |
| Electric Power | RF |
| Targets | Co (diameter of 100mm) and Al₂O₃ chip (130 pieces) (chip size: 5mm × 5mm × 2mm) |

The properties of film sample 5 are show in Table 5.

**Table 5**

| | |
|---|---|
| Film thickness | 1.1 µm |
| {Ms(M-X-Y)/Ms(M)} × 100 | 64.7% |
| µ"ₘₐₓ | 850 |
| f(µ"ₘₐₓ) | 800MHz |
| bwr | 157% |

### Example 6 (Comparative)

A thin film of M-X-Y magnetic composition was made on a glass plate by the reactive sputtering method using the sputtering apparatus shown in Fig. 2A at a sputtering condition shown in Table 6. The partial pressure ratio of N₂ was 10%. The thin film was heat-treated at a temperature of 300°C for two hours in vacuum under magnetic field and obtained a film sample 6.

**Table 6**

| | |
|---|---|
| Vacuum degree before sputtering | < 1.33 · 10⁻⁴ Pa (1 × 10⁻⁶ Torr) |
| Atmosphere | Ar+N₂ gas |
| Electric Power | RF |
| Targets | Co (diameter of 100mm) and Al chip (170 pieces) (chip size: 5mm × 5mm × 2mm) |

The properties of film sample 6 are show in Table 7.

**Table 7**

| | |
|---|---|
| Film thickness | 1.2 µm |
| {Ms(M-X-Y)/Ms(M)} × 100 | 32.7% |
| µ"ₘₐₓ | 350 |
| f(µ"ₘₐₓ) | 1GHz |
| bwr | 191% |

### Example 7

A thin film of M-X-Y magnetic composition was made on a glass plate by using the sputtering apparatus shown in Fig. 2A at a sputtering condition shown in Table 8. The thin film was heat-treated at a temperature of 300°C for two hours in vacuum under magnetic field and obtained a film sample 7.

**Table 8**

| | |
|---|---|
| Vacuum degree before sputtering | < 1.33 × 10⁻⁴ Pa (1 × 10⁻⁶ Torr) |
| Atmosphere | Ar gas |
| Electric Power | RF |
| Targets | Ni (diameter of 100mm) and Al₂O₃ chip (140 pieces) (chip size: 5mm × 5mm × 2mm) |

The properties of film sample 4 are show in Table 9.

**Table 9**

| | |
|---|---|
| Film thickness | 1.7 µm |
| {Ms(M-X-Y)/Ms(M)} × 100 | 58.2% |
| µ"ₘₐₓ | 280 |
| f(µ"ₘₐₓ) | 240MHz |
| bwr | 169% |

### Example 8

A thin film of M-X-Y magnetic composition was made on a glass plate by the reactive sputtering method using the sputtering apparatus shown in Fig. 2A at a sputtering condition shown in Table 10. The partial pressure ratio of N₂ was 10%. The thin film was heat-treated at a temperature of 300°C for two hours in vacuum under magnetic field and obtained a film sample 8.

**Table 10**

| | |
|---|---|
| Vacuum degree before sputtering | < 1.33 · 10⁻⁴ Pa (1 × 10⁻⁶ Torr) |
| Atmosphere | Ar+N₂ gas |
| Electric Power | RF |
| Targets | Ni (diameter of 100mm) and Al chip (100 pieces) (chip size: 5mm × 5mm × 2mm) |

The properties of film sample 10 are show in Table 11.

**Table 11**

| | |
|---|---|
| Film thickness | 1.3 µm |
| {Ms(M-X-Y)/Ms(M)} × 100 | 76.2% |
| µ"ₘₐₓ | 410 |
| f(µ"ₘₐₓ) | 170MHz |
| bwr | 158% |

### Example 9

A thin film of M-X-Y magnetic composition was made on a glass plate by using the sputtering apparatus shown in Fig. 2A at a sputtering condition shown in Table 12. The thin film was heat-treated at a temperature of 300°C for two hours in vacuum under magnetic field and obtained a film sample 9.

**Table 12**

| | |
|---|---|
| Vacuum degree before sputtering | < 1.33 × 10⁻⁴ Pa (1 × 10⁻⁶ Torr) |
| Atmosphere | Ar gas |
| Electric Power | RF |
| Targets | Fe (diameter of 100mm) and TiO₂ chip (150 pieces) (chip size: 5mm × 5mm × 2mm) |

The properties of film sample 9 are show in Table 13.

**Table 13**

| | |
|---|---|
| Film thickness | 1.4 µm |
| {Ms(M-X-Y)/Ms(M)} × 100 | 43.6% |
| µ"ₘₐₓ | 920 |
| f(µ"ₘₐₓ) | 1.5GHz |
| bwr | 188% |

### Example 10

A thin film of M-X-Y magnetic composition was made on a glass plate by the reactive sputtering method using the sputtering apparatus shown in Fig. 2A at a sputtering condition shown in Table 14. The partial pressure ratio of O₂ was 15%. The thin film was heat-treated at a temperature of 300°C for two hours in vacuum under magnetic field and obtained a film sample 10.

**Table 14**

| | |
|---|---|
| Vacuum degree before sputtering | < 1.33 × 10⁻⁴ Pa (1 × 10⁻⁶ Torr) |
| Atmosphere | Ar+O₂ gas |
| Electric Power | RF |
| Targets | Fe (diameter of 100mm) and Si chip (130 pieces) (chip size: 5mm × 5mm × 2mm) |

The properties of film sample 10 are show in Table 15.

**Table 15**

| | |
|---|---|
| Film thickness | 1.5 µm |
| {Ms(M-X-Y)/Ms(M)} × 100 | 55.2% |
| µ"ₘₐₓ | 920 |
| f(µ"ₘₐₓ) | 1.2GHz |
| bwr | 182% |

### Example 11

A thin film of M-X-Y magnetic composition was made on a glass plate by using the sputtering apparatus shown in Fig. 2A at a sputtering condition shown in Table 16. The thin film was heat-treated at a temperature of 300°C for two hours in vacuum under magnetic field and obtained a film sample 11.

**Table 16**

| | |
|---|---|
| Vacuum degree before sputtering | < 1.33 × 10⁻⁴ Pa (1 × 10⁻⁶ Torr) |
| Atmosphere | Ar gas |
| Electric Power | RF |
| Targets | Fe (diameter of 100mm) and HfO₃ chip (100 pieces) (chip size: 5mm × 5mm × 2mm) |

The properties of film sample 11 are show in Table 17.

**Table 17**

| | |
|---|---|
| Film thickness | 1.8 µm |
| {Ms(M-X-Y)/Ms(M)} × 100 | 77.4% |
| µ"ₘₐₓ | 1800 |
| f( µ"ₘₐₓ) | 450MHz |
| bwr | 171% |

### Example 12

A thin film of M-X-Y magnetic composition was made on a glass plate by using the sputtering apparatus shown in Fig. 2A at a sputtering condition shown in Table 18. The thin film was heat-treated at a temperature of 300°C for two hours in vacuum under magnetic field and obtained a film sample 12.

**Table 18**

| | |
|---|---|
| Vacuum degree before sputtering | < 1.33 × 10⁻⁴ Pa (1 × 10⁻⁶ Torr ) |
| Atmosphere | Ar gas |
| Electric Power | RF |
| Targets | Fe (diameter of 100mm) and BN chip (130 pieces) (chip size: 5mm × 5mm × 2mm) |

The properties of film sample 12 are show in Table 19.

**Table 19**

| | |
|---|---|
| Film thickness | 1.9 µm |
| {Ms(M-X-Y)/Ms(M)} × 100 | 59.3% |
| µ"ₘₐₓ | 950 |
| f(µ"ₘₐₓ) | 680MHz |
| bwr | 185% |

### Example 13

A thin film of M-X-Y magnetic composition was made on a glass plate by using the sputtering apparatus shown in Fig. 2A at a sputtering condition shown in Table 20. The thin film was heat-treated at a temperature of 300°C for two hours in vacuum under magnetic field and obtained a film sample 13.

**Table 20**

| | |
|---|---|
| Vacuum degree before sputtering | < 1.33 × 10⁻⁴ Pa (1 × 10⁻⁶ Torr) |
| Atmosphere | Ar gas |
| Electric Power | RF |
| Targets | Fe₅₀Co₅₀ (diameter of 100mm) and Al₂O₃ chip (130 pieces) (chip size: 5mm × 5mm × 2mm) |

The properties of film sample 13 are show in Table 21.

**Table 21**

| | |
|---|---|
| Film thickness | 1.6 µm |
| {Ms(M-X-Y)/Ms(M)} × 100 | 59.3% |
| µ"ₘₐₓ | 720 |
| f(µ"ₘₐₓ) | 1.1GHz |
| bwr | 180% |

### Example 14

A thin film of M-X-Y magnetic composition was made on a glass plate by using the vapor deposition apparatus shown in Fig. 2B at a condition shown in Table 22. The thin film was heat-treated at a temperature of 300°C for two hours in vacuum under magnetic field and obtained a film sample 14.

**Table 22**

| | |
|---|---|
| Vacuum degree before sputtering | < 1.33 × 10⁻⁴ Pa (1 × 10⁻⁶ Torr) |
| Atmosphere flowing rate | O₂ at 3.0 sccm |
| Elements in crucible 28 and 29 | Fe and Al |

The properties of film sample 14 are show in Table 23.

**Table 23**

| | |
|---|---|
| Film thickness | 1.1 µm |
| {Ms(M-X-Y)/Ms(M)} × 100 | 41.8% |
| µ"ₘₐₓ | 590 |
| f(µ"ₘₐₓ) | 520MHz |
| bwr | 190% |

Now, description will be made as to tests relating to noise suppressing effect of sample films and comparative samples, using a test apparatus shown in Fig. 6.

A test piece was film sample 1 with dimensions of 20mm × 20mm × 2.0 µm. For a comparison, a sheet of known composite magnetic material having dimensions of 20mm × 20mm × 1.0mm. The composite magnetic material comprising polymer and flat magnetic metal powder dispersed in the polymer. The magnetic metal powder comprises Fe, Al and Si. The composite magnetic material has a complex permeability distribution in quasi-microwave range and has the maximum value of the complex permeability at a frequency about 700 MHz. Table 24 shows magnetic properties of both of the test piece and comparative test piece.

**Table 24**

| | Film sample 1 | Comparative test piece |
|---|---|---|
| µ"/700MHz | about 1800 | about 3.0 |
| bwr | 148 | 196 |

As seen from Table 24, the film sample 1 is about 600 times more than comparative test piece in the maximum value of complex permeability. Since the noise suppressing effect is generally evaluated from a value of a product (µ"ₘₐₓ × δ) of the maximum complex permeability µ"ₘₐₓ and thickness of the piece δ, the thickness of the comparative test piece of the composite magnetic material sheet was selected 1 mm so that the both of test pieces have the similar values of (µ"ₘₐₓ × δ).

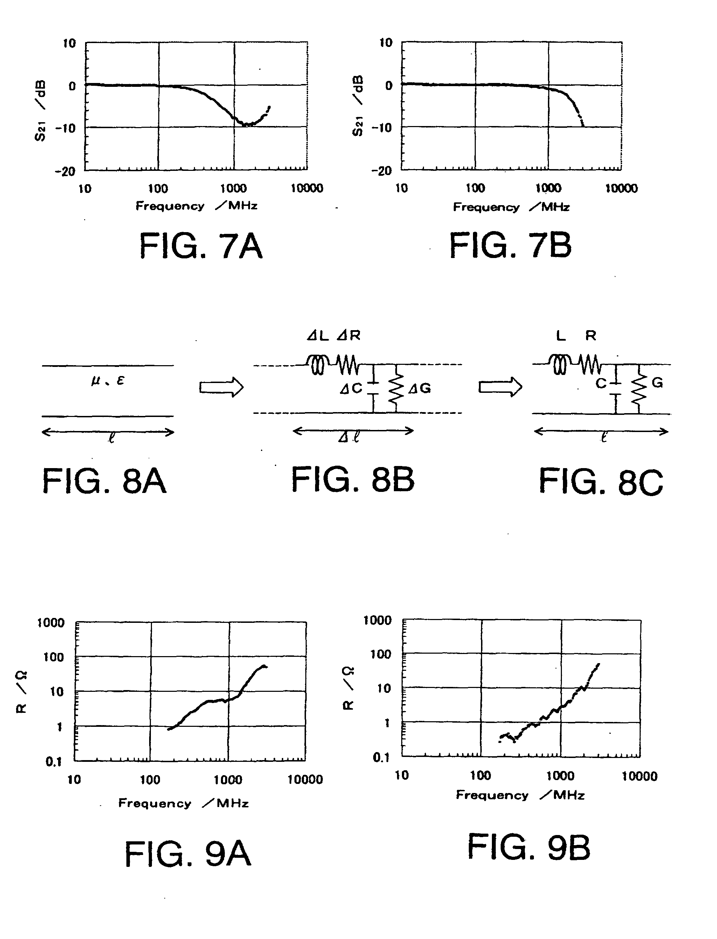

Referring to Fig. 6, the test apparatus comprises a micro-strip line 61 having two ports, coaxial cables 62 connected to the two ports, and a network analyzer (not shown) connected across the two ports. The micro-strip line 61 has a line length of 75mm and a characteristic impedance of 50 ohms. The test piece 63 was disposed at a region 64 on the micro-strip line 61 and the transmission characteristic S21 was measured. The frequency response of S21 are shown in Figs. 7A and 7b for film sample 1 and the comparative sample, respectively.

With respect to use of film sample 1, it will be noted from Fig. 7A that S21 reduces above 100 MHz, becomes to the minimum of -10dB at a frequency of 2 GHz and then increases above 2 GHz. On the other hand, with respect to use of comparative sample, it will be noted from Fig. 7B that S21 gradually reduces and becomes to the minimum of -10dB at a frequency of 3GHz.

The results demonstrate that S21 is dependent on the frequency distribution of the complex permeability and that the noise suppressing effect is dependent on the product of (µ"ₘₐₓ × δ).

Now, providing that the magnetic sample forms a distribution constant circuit having a length of ℓ as shown in Fig. 8A, an equivalent circuit was calculated for a unit length of Δℓ from transmission characteristics S11 and S21, as shown in Fig. 8B. Then, the equivalent circuit for the length ℓ was obtained from the equivalent circuit for the unit length Δℓ, as shown in Fig. 8C. The equivalent circuit of the magnetic sample comprises series inductance L and resistance R and parallel capacitance C and conductance G, as shown in Fig. 8C. From this, it will be understood that the change of transmission characteristic of the micro-strip line caused due to disposition of the magnetic substance on the micro-strip line is mainly determined by the equivalent resistance R added in series.

In view of the above, a frequency response of the equivalent resistance R was measured. The measured data were shown in Figs. 9A and 9B for the film sample 1 and the comparative sample, respectively. It will be noted from these figures that the equivalent resistance R gradually reduces in the quasi-microwave range and is about 60 ohms at about 3 GHz. It is seen that the frequency dependency of the equivalent resistance R is different from that of the complex permeability which has the maximum value at about 1 GHz. It will be supposed that this difference will be based on the gradual increase of a ratio of the product and the sample length to the wavelength.

Production method of the magnetic substance of this invention has been described as to the sputtering method and the vapor deposition method but they do not restrict the production method. Any other film producing method such as ion beam deposition method and gas deposition method can be used for production of the magnetic substance of the present invention if they can evenly produce the magnetic substance of the present invention. Further, the heat treatment after film production is not necessary if the film as produced has a sufficient property.

### Industrial Applicability

According to the present invention, the magnetic substance having a higher complex permeability in a high frequency such as a quasi-microwave range. Therefore, the magnetic substance according to the present invention can provide a noise suppressor which is useful in the small-sized electronic circuit elements and electronic apparatus.

## Claims

1. A use of a magnetic substance for suppression of a high frequency noise of an electric and electronic apparatus, said magnetic substance of a magnetic composition comprising M, X and Y, where M is a metallic magnetic material consisting of at least one of Fe, Co, and Ni, Y is at least one of F, N and O, and X is element or elements other than M and Y, wherein the M-X-Y magnetic composition has a saturation magnetization of 35-80% of that of a metallic bulk of magnetic material comprising M alone,
the magnetic composition having the maximum µ"ₘₐₓ of complex permeability µ" in a frequency range of 0.1-10 gigahertz (GHz),
wherein the metallic magnetic material M is distributed as granular grains in a matrix composition consisting of X and Y.

2. The use of the magnetic substance according to claim 1, wherein the M-X-Y magnetic composition has a concentration of M so that the M-X-Y magnetic composition has the aforementioned saturation magnetization.

3. The use of the magnetic substance according to claim 1 or 2, wherein the magnetic substance has a complex permeability frequency response of a frequency band where a relative bandwidth bwr is 200% or less, the relative bandwidth bwr is determined as a percentage ratio of bandwidth between two frequency points which shows the complex permeability as a half value µ"₅₀ of the maximum µ"ₘₐₓ, to center frequency of the bandwidth.

4. The use of the magnetic substance according to claim 3, wherein the magnetic saturation of the M-X-Y magnetic composition is 60-80% of that of the metallic bulk of a magnetic material comprising M alone.

5. The use of the magnetic substance according to claim 3 or 4, wherein the magnetic substance has a DC specific resistance of 100-700 µΩ*cm.

6. The use of the magnetic substance according to claim 1 or 2, wherein the magnetic substance has a complex permeability frequency response of a frequency band where a relative bandwidth bwr is 148% or more, the relative bandwidth bwr is determined as a percentage ratio of bandwidth between two frequency points which shows the complex permeability as a half value µ"₅₀ of the maximum µ"ₘₐₓ, to center frequency of the bandwidth.

7. The use of the magnetic substance according to one of claims 1-6, wherein X comprises at least one of C, Bi, Si, Al, Mg, Ti, Zn, Hf, Sr, Nb, Ta and a rare-earth metal.

8. The use of the magnetic substance according to claim 1, wherein the granular grains have an average grain size of 1-40nm.

9. The use of the magnetic substance according to one of claims 1-8, wherein the magnetic composition has an anisotropy field of 47746 A/m (600Oe) or less.

10. The use of the magnetic substance according to one of claims 1-9, wherein the magnetic composition is a composition represented by a formula of Fe_{α}-Al_{β}-O_{γ}.

11. The use of the magnetic substance according to one of claims 1-9, wherein the magnetic composition is a composition represented by a formula of Fe_{α}-Si_{β}-O_{γ}.

12. The use of the magnetic substance according to one of claims 1-11, wherein the magnetic substance is a thin film obtainable by sputtering process.

13. The use of the magnetic substance according to one of claims 1-11, wherein the magnetic substance is a thin film obtainable by vapor deposition process.

14. The use of the magnetic substance according to one of claims 1-9, wherein the magnetic substance is a plate which has a thickness of 0.3-20 µm.

## Patentansprüche

1. Verwendung einer magnetischen Substanz zur Unterdrückung eines Hochfrequenzrauschens eines elektrischen und elektromagnetischen Gerätes, wobei die magnetische Substanz eine magnetischen Zusammensetzung aufweist,
worin M ein metallisches magnetisches Material ist, das aus mindestens einem von Fe, Co und Ni besteht, Y mindestens eines von F, N und O ist und X ein Element oder Elemente ungleich M und Y ist,
worin die magnetische M-X-Y-Zusammensetzung eine Sättigungsmagnetisierung von 35-80% der einer metallischen Masse von magnetischem Material aufweist, das M allein aufweist,
wobei die magnetische Zusammensetzung das maximale µ"ₘₐₓ komplexer Permeabilität µ" in einem Frequenzbereich von 0,1-10 Gigahertz (GHz) aufweist,
worin das metallische magnetische Material M als granulöse Körnchen in einer Matrixzusammensetzung, die aus X und Y besteht, verteilt ist.

2. Benutzung der magnetischen Substanz nach Anspruch 1, bei der die magnetische M-X-Y-Zusammensetzung eine Konzentration von M so aufweist, daß die magnetische M-X-Y-Zusammensetzung die zuvor erwähnte Sättigungsmagnetisierung aufweist.

3. Die Benutzung der magnetischen Substanz nach Anspruch 1 oder 2, bei der die magnetische Substanz eine komplexe Permeabilitätsfrequenzantwort eines Frequenzbandes aufweist, wobei die relative Bandbreite bwr 200% oder weniger ist, die relative Bandbreite bwr als ein Prozentverhältnis der Bandbreite zwischen zwei Frequenzpunkten bestimmt ist, die die komplexe Permeabilität als einen Halbwert µ"₅₀ des maximalen µ"ₘₐₓ zu der Zentralfrequenz der Bandbreite zeigt.

4. Benutzung der magnetischen Substanz nach Anspruch 3, bei der die magnetische Sättigung der magnetischen M-X-Y-Zusammensetzung 60-80% der metallischen Masse des magnetischen Materials, das M alleine aufweist, beträgt.

5. Benutzung der magnetischen Substanz nach Anspruch 3 oder 4, bei der die magnetische Substanz einen spezifischen Gleichstromwiderstand von 100-700 µΩ x cm aufweist.

6. Benutzung der magnetischen Substanz nach Anspruch 1 oder 2, bei der die magnetische Substanz eine komplexe Permeabilitätsfrequenzantwort eines Frequenzbandes aufweist, wobei eine relative Bandbreite bwr 148% oder mehr ist, die relative Bandbreite bwr als ein Prozentverhältnis der Bandbreite zwischen zwei Frequenzpunkten bestimmt ist, die die komplexe Permeabilität als einen Halbwert µ"₅₀ des maximalen µ"ₘₐₓ der Zentralfrequenz der Bandbreite zeigt.

7. Benutzung der magnetischen Substanz nach einem der Ansprüche 1 bis 6, bei der X mindestens eines von C, Bi, Si, Al, Mg, Ti, Zn, Hf, Sr, Nb, Ta und ein Seltenerdmetall aufweist.

8. Benutzung der magnetischen Substanz nach Anspruch 1, bei der die granulösen Körnchen eine mittlere Körnchengröße von 1-40 nm aufweisen.

9. Benutzung der magnetischen Substanz nach einem der Ansprüche 1 bis 8, bei der die magnetische Zusammensetzung ein anisotropes Feld von 47.746 A/m (600 Oe) oder weniger aufweist.

10. Benutzung der magnetischen Substanz nach einem der Ansprüche 1 bis 9, bei der die magnetische Zusammensetzung eine Zusammensetzung ist, die durch eine Formel von Fe_{α}-Al_{β}-Oy dargestellt ist.

11. Benutzung der magnetischen Substanz nach einem der Ansprüche 1 bis 9, bei der die magnetische Zusammensetzung eine Zusammensetzung ist, die durch eine Formel von Fe_{α}-Si_{β}-O_{γ} dargestellt ist.

12. Benutzung der magnetischen Substanz nach einem der Ansprüche 1 bis 11, bei der die magnetische Substanz ein dünner Film ist, der durch einen Sputter-Prozeß erhältlich ist.

13. Benutzung der magnetischen Substanz nach einem der Ansprüche 1 bis 11, bei der die magnetische Substanz ein dünner Film ist, der durch einen Dampfabscheidungsprozeß erhältlich ist.

14. Benutzung der magnetischen Substanz nach einem der Ansprüche 1 bis 9, bei der die magnetische Substanz eine Platte mit einer Dicke von 0,3-20 µm ist.

## Revendications

1. Utilisation d'une substance magnétique pour supprimer un bruit à haute fréquence d'un appareil électronique et électrique,
la substance magnétique ayant une composition magnétique comprenant M, X, Y,
M étant un métal magnétique correspondant à au moins l'un des éléments Fe, Co, Ni,
Y est au moins l'un des éléments F, N, O,
X est un ou des éléments autres que M et Y,
la composition magnétique M-X-Y ayant une aimantation de saturation de 35-80 % du métal magnétique en vrac contenant L seul,
la composition magnétique ayant le maximum µ" max de perméabilité complexe µ" dans une plage de fréquences de 0,1-10 gigahertz (GHz), et
le métal magnétique M étant réparti sous la forme de grains dans une matrice formée de X et Y.

2. Utilisation de la substance magnétique selon la revendication 1
dans laquelle
la composition magnétique M-X-Y a une concentration en M telle qu'elle présente l'aimaniation de saturation mentionnée ci-dessus.

3. Utilisation de la substance magnétique selon la revendication 1 ou 2,
dans laquelle
la substance magnétique a une perméabilité complexe de fréquence pour une bande de fréquence d'une largeur de bande relative bwr égale à 200 % ou moins, la largeur de bande relative bwr étant déterminée comme pourcentage de largeur de bande entre deux points de fréquence présentant la perméabilité complexe de valeur moitié µ"₅₀ par rapport au maximum µ"ₘₐₓ vis-à-vis de la fréquence centrale de la largeur de bande.

4. Utilisation de la substance magnétique selon la revendication 3,
**caractérisée en ce que**
la saturation magnétique de la composition magnétique M-X-Y représente entre 60-80 % de celle du métal en vrac, comprenant uniquement M.

5. Utilisation de la substance magnétique selon la revendication 3 ou 4,
**caractérisée en ce que**
la substance magnétique a une résistance spécifique continue de 100-700 µΩ*cm.

6. Utilisation de la substance magnétique selon la revendication 1 ou 2,
**caractérisée en ce que**
la substance magnétique a une perméabilité complexe de réponse en fréquence pour une brande de fréquence d'une largeur de bande relative bwr correspondant à 148 % ou plus, la largeur de bande relative bwr se déterminant comme pourcentage de largeur de bande comprise entre deux points de fréquence présentant la perméabilité complexe moitié µ"₅₀ par rapport à la perméabilité complexe maximale µ"ₘₐₓ vis-à-vis de la fréquence centrale de la largeur de bande.

7. Utilisation de la substance magnétique selon l'une des revendications 1 à 6,
**caractérisée en ce que**
X correspond à au moins l'un des éléments C, Bi, Si, Al, Mg, Ti, Zn, Hf, Sr, Nb, Ta et un métal de terres rares.

8. Utilisation de la substance magnétique selon la revendication 1,
**caractérisée en ce que**
les grains ont une dimension moyenne de grain de 1-40 nm.

9. Utilisation de la substance magnétique selon l'une des revendications 1 à 8,
**caractérisée en ce que**
la composition magnétique présente un champ anisotrope de 47746 A/m (600Oe) ou moins.

10. Utilisation de la substance magnétique selon l'une des revendications 1 à 9,
**caractérisée en ce que**
la composition magnétique est représentée par la formule Fe_{α}-Al_{β}-O_{γ}.

11. Utilisation de la substance magnétique selon l'une des revendications 1 à 9,
**caractérisée en ce que**
la composition magnétique est représentée par la formule Fe_{α}-Si_{β}-O_{γ}.

12. Utilisation de la substance magnétique selon l'une des revendications 1 à 11,
**caractérisée en ce que**
la substance magnétique est un film mince obtenu par pulvérisation.

13. Utilisation de la substance magnétique selon l'une des revendications 1 à 11,
**caractérisée en ce que**
la substance magnétique est un film mince obtenu par un procédé de dépôt à la vapeur.

14. Utilisation de la substance magnétique selon l'une des revendications 1 à 9,
**caractérisée en ce que**
la substance magnétique est une plaque d'une épaisseur comprise entre 0,3 et 20 µm.
